# EUROPEAN PATENT APPLICATION

(11) **EP 3 557 325 A1**
(43) Date of publication of application: **23.10.2019**
(21) Application number: 18167948.1
(22) Date of filing: 18.04.2018
(51) Int. Cl.: G03F 7/00, G03F 7/004, G03F 7/027, G03F 7/029, G03F 7/031, A61L 15/00

(54) **3D PRINTABLE POLY HIGH INTERNAL PHASE EMULSION**

(71) Applicant: Nederlandse Organisatie voor toegepast- natuurwetenschappelijk onderzoek TNO, 2595 DA 's-Gravenhage (NL); Chemelot Scientific Participations B.V., 6167 RD Geleen (NL)
(72) Inventor: ten Cate, Aafke Tessa, 2595 DA 's-Gravenhage (NL); Ingenhut, Bastiaan Leonardus Joseph, 2595 DA 's-Gravenhage (NL); Bex, Guy Johan Peter, 2595 DA 's-Gravenhage (NL); Segers, Margot Jacoba Andrea, 2595 DA 's-Gravenhage (NL)
(74) Representative: V.O.

(57) **Abstract**

The invention discloses a high internal phase emulsion, a method of preparing a three-dimensional article, a kit-of-parts for forming a high internal phase emulsion, a three-dimensional article, and uses of the three-dimensional article.

The high internal phase emulsion of the invention comprises a solvent, at least two radiation curable monomers of which at least one hydrophilic monomer, a photoinitiator, and a surfactant, wherein the high internal phase emulsion has a discontinuous phase volume fraction of 0.73 or more, and wherein the dynamic viscosity of the high internal phase emulsion is 0.01-30 Pa·s at 25 °C.

## Description

The invention is directed to a high internal phase emulsion, a method of preparing a three-dimensional article from the high internal phase emulsion, a kit-of-parts for forming the high internal phase emulsion, the three-dimensional article, and a use of the three-dimensional article for biomedical applications.

Porous materials are widely used as support materials because of their ability to interact with molecules not only at their surface, but also throughout their network. Traditionally, porous materials are applied in catalytic processes, and separation techniques. Nowadays, tissue engineering is becoming ever important as the demand for implant materials and tissue scaffolds is growing. Regenerative processes focused on creating *in vitro* cellular tissue are desirable as well.

In order to culture cellular material *in vitro,* the cells need to adhere to a support that will guarantee their structure, function and safeguard their survivability. In most cases, a hydrophilic support is desired. Polymerised high internal phase emulsions, also referred to as polyHIPEs, are well-known materials that function as supports because of their porous structure.

For example, US-A-5 260 345 discloses flexible, microporous, open-celled polymeric foam materials which have fluid absorption and retention characteristics.

US-A-2015/0 100 008 discloses a wound dressing comprising two layers of polymerised HIPEs for treating a wound. The layer facing the wound has a smaller pore size compared to the second layer which serves as a back layer.

Such porous materials are consequently made from polymerisable high internal phase emulsions, also referred to as polyHIPE or polyHIPEs.

In general, high internal phase emulsions are considered water-in-oil (w/o) emulsions in which a discontinuous aqueous phase is dispersed in a continuous hydrophobic phase. This type of emulsion is characterised in that it contains at least 70 vol.% of discontinuous phase.

Regarding polyHIPEs, the continuous phase generally comprises polymerisable monomeric species, such as (meth-)acrylates, and a chemical crosslinking agent, such as bi- or polyfunctional (meth-)acrylates, whereas the discontinuous phase typically comprises water and a water soluble electrolyte. To obtain a sufficiently stable emulsion, one or more surfactants (or emulsifiers) are added, characterised in that their hydrophilic-lipophilic balance (HLB) value corresponds to that required for the particular emulsion. Non-ionic surfactants are commonly used, examples of which include sorbitan esters, amphiphilic block copolymers and long-chain aliphatic alcohols.

The relative amounts of water and oil phases used to form the HIPE are, among many other parameters, important in determining the structural, mechanical and performance properties of the resulting polyHIPE. In particular, the ratio of w/o in the HIPE can influence density, pore size, permeability, and specific surface area of the support. By subjecting the emulsion to polymerisation conditions and/or curing conditions, a solidified porous material is obtained.

For example, Jerenec et al. (Reactive & Functional Polymers 2014, 78, 32-37) describe the dropwise addition of an aqueous phase to an organic phase. Addition of the polymerisation activator *N,N,N',N'*-tetramethylethylenediamine (TEMED), followed by curing at 40 °C during 24 hours, results in the corresponding polyHIPE. Jerenec *et al.* neither report hydrophilic support structures, nor suggest other methods of acquiring support structures.

Sears et al. (Macromol. Rapid Commun. 2016, 37(16), 1369-1374) report HIPEs suitable for three-dimensional printing of polyHIPE constructs. The HIPEs function as photocurable emulsion inks wherewith porous constructs can be manufactured by means of layer-by-layer deposition using solid freeform fabrication technique. Hydrophilic support structures are not reported by Sears *et al.*

Cameron et al. (Reactive & Functional Polymers 2012, 72(12), 947-954) reveal the preparation of highly porous and interconnected methacrylate-based porous materials by photopolymerisation of HIPEs. While the majority of reported polyHIPEs are initially hydrophobic, hydrophilic support structures are obtained after hydrolysis of the glycidyl moieties.

Current technologies require either long curing times, are energy inefficient, costly, and/or give the operator minimal influence on physical properties (*i.e*. low freedom of design).

There is a need to prepare hydrophilic articles of HIPEs by a means of short processing time, reduced production costs, high freedom of design, and preferably wherewith physical properties, such as pore size and porosity, can be tuned.

An objective of the invention is to overcome one or more of the disadvantages faced in the prior art.

A further objective of the invention is to provide a high internal phase emulsion that remains stable during processing.

A further objective of the invention is to provide a high internal phase emulsion that can be cured to a three-dimensional article without using a mould.

A further objective of the invention is to provide a high internal phase emulsion that can be cured to a three-dimensional article by using 3D printing technologies.

A further objective of the invention is to provide a hydrophilic three-dimensional article.

A further objective of the invention is to provide a hydrophobic three-dimensional article.

A further objective of the invention is to provide a method of preparing a three-dimensional article from a curable high internal phase emulsion.

A further objective of the invention is to provide a method of curing a high internal phase emulsion by means of digital light processing.

A further objective of the invention is to provide a method of preparing a three-dimensional article by means of stereolithography.

Yet a further objective of the invention is to provide a three-dimensional article that can be used as a scaffold for cell growth, medical implants, encapsulation material for pharmaceutical substances, and as a membrane, for example for lab or organ on a chip.

Accordingly, in a first aspect the invention provides a high internal phase emulsion comprising:
- a solvent;
- at least two radiation curable monomers of which at least one hydrophilic monomer, and
- a surfactant,
wherein the high internal phase emulsion has a discontinuous phase volume fraction of 0.73 or more, and wherein the dynamic viscosity of the high internal phase emulsion is 0.01-100 Pa·s at 25 °C.

In a second aspect the invention provides a method of preparing a three-dimensional article comprising the following steps:
a) preparing a high internal phase emulsion according to the high internal phase emulsion of the invention;
b) preparing the three-dimensional article, comprising the steps:
   1) applying a layer of the high internal phase emulsion onto a surface;
   2) exposing the layer image wise to radiation to form an imaged cross-section;
   3) applying a layer of the high internal phase emulsion onto the exposed imaged cross-section;
   4) exposing the layer from step 3) to radiation to form an additional imaged cross-section, and
   5) repeating steps 3) and 4) to build up the three-dimensional article, and
c) optionally cleaning the three-dimensional article using solvent;
d) optionally removing solvent by drying, and
e) optionally exposing the three-dimensional article to radiation.

In a third aspect the invention provides a kit-of-parts for forming the high internal phase emulsion according to the invention, the kit comprising,
a first container which comprises one or more of:
   - a solvent;
   - one or more additives, and
a second container which comprises one or more of:
   - at least two radiation curable monomers;
   - a photoinitiator;
   - a surfactant;
   - one or more additives, and
a third container which comprises:
   - at least one hydrophilic monomer.

In a fourth aspect the invention provides a three-dimensional article obtainable by the method according to the invention.

In a fifth aspect the invention provides a use of the three-dimensional article according to the invention, such as a scaffold for cell growth, medical implants, encapsulation material for pharmaceutical substances, and as membrane, for example for lab or organ on a chip.

A hydrophilic three-dimensional article can be prepared from a water-in-oil curable high internal phase emulsion.

The high internal phase emulsion asks for a modular approach, such as a separate hydrophilic and hydrophobic phase.

The pore size and porosity of the three-dimensional article can be controlled by the composition of the high internal phase emulsion.

The three-dimensional article can be made with reduced processing time and production costs.

By using 3D printing technologies, the pore size and porosity of the three-dimensional article can be tuned.

Shelf life of the high internal phase emulsion can be improved by adding one or more salts.

The three-dimensional article can be used for implants.

The three-dimensional article allows for pharmaceutical applications.

The invention further allows the three-dimensional article to host cells for culturing without adversely affecting growth.

The expression *"high internal phase emulsion"* as used in the invention is meant to include emulsions of which more than 70 %, by total volume of the emulsion, comprises a discontinuous, internal, or dispersed, phase. Commonly, their defining feature is an internal phase volume fraction of 0.73 or greater.

The expression *"emulsion"* as described herein is meant to include the expression *"HIPE",* which is subsequently used in the invention as an abbreviation of *"high internal phase emulsion".* A person skilled in the art may consider an emulsion as a colloidal system of two or more immiscible liquids, wherein one liquid or liquid mixture contains a dispersion of other liquids. Suitable general examples include water-in-oil (w/o) and oil-in-water (o/w) emulsions.

The expression *"poly high internal phase emulsion"* as described herein is meant to include the polymerised high internal phase emulsion. The above expression may be abbreviated herein as *"polyHIPE".* The three-dimensional article as described herein may comprise a poly high internal phase emulsion.

The high internal phase emulsion according to the invention comprises a solvent. The solvent may be part of the continuous and/or discontinuous phase. In case of a w/o emulsion, the solvent may be part of the water phase or the oil phase. The solvent preferably does not destabilise the high internal phase emulsion. The solvent may also be a mixture of solvents.

When the water phase comprises a solvent, the solvent may comprise one or more solvents selected from the groups consisting of aqueous, and polar organic solvents. Preferably, the solvent or solvent mixture is not miscible with the continuous phase. Polar organic solvents may comprise one or more selected from the group consisting of tetrahydrofuran, ethyl acetate, acetone, dimethylformamide, acetonitrile, dimethyl sulphoxide, nitromethane, propylene carbonate, acetic acid, *n*-butanol, isopropanol, *n*-propanol, ethanol, methanol, and formic acid. Preferably, water or a protic polar solvent is selected, comprising one or more selected from the group consisting of acetic acid, *n*-butanol, isopropanol, *n*-propanol, ethanol, methanol, formic acid, and water. Preferably, the solvent comprises water.

In case the oil phase comprises a solvent, the solvent may comprise one or more examples selected from the solvent collector groups consisting of non-polar organic, inorganic non-aqueous, and polar organic. In particular, non-polar organic solvents may be selected. Preferably, the solvent is not miscible with the dispersed (or discontinuous) phase. Non-polar organic solvents may comprise one or more selected from the group consisting of aliphatic solvents, such as hexane, heptane, cyclohexane, benzene, toluene, diethyl ether, chloroform, and dioxane. Preferably, a non-polar organic solvent is selected, comprising toluene and/or cyclohexane.

The concentration of solvent in the oil phase of a w/o emulsion may be 0.1 % or more to 5 % or less, based on the total volume of the emulsion. Preferably, the concentration is 4 vol.% or less, 3 vol.% or less, 2 vol.% or less, or 1 vol.% or less. More preferably, the concentration ranges from 0.1-1 vol.%. The solvent may be of technical grade and/or analytical grade.

The concentration of solvent in the water phase of a w/o emulsion may be 50 % or more to 95 % or less, based on the total volume of the emulsion. Preferably, the concentration may be 90 vol.% or less, 85 vol.% or less, 80 vol.% or less, 75 vol.% or less, 70 vol.% or less, 60 vol.% or less, or 55 vol.% or less. More preferably, the concentration ranges from 73-80 vol.%. The solvent may be of technical grade and/or analytical grade.

At least two radiation curable monomers are present in the high internal phase emulsion according to the invention. In particular, the radiation curable monomers are water insoluble. The at least two radiation curable monomers may comprise one or more selected from the group consisting of acrylates, methacrylates, bi- or polyfunctional (meth)acrylates, (meth)acrylamides, epoxides, oxetanes, vinyl aliphatics and/or vinyl aromatics.

Examples of acrylates and methacrylates include 2-ethylhexyl (meth)acrylate, isobornyl (meth)acrylate, bornyl (meth)acrylate, tricyclodecanyl (meth)acrylate, dicyclopentanyl (meth)acrylate, dicyclopentenyl (meth)acrylate, cyclohexyl (meth)acrylate, benzyl (meth)acrylate, 4-butylcyclohexyl (meth)acrylate, acryloyl morpholine, (meth)acrylic acid, 2-hydroxyethyl (meth)acrylate, 2-hydroxypropyl (meth)acrylate, 2-hydroxybutyl (meth)acrylate, methyl (meth)acrylate, ethyl (meth)acrylate, propyl (meth)acrylate, isopropyl (meth)acrylate, butyl (meth)acrylate, isobutyl (meth)acrylate, *t*-butyl (meth)acrylate, pentyl (meth)acrylate, caprolactone acrylate, isoamyl (meth)acrylate, hexyl (meth)acrylate, heptyl (meth)acrylate, octyl (meth)acrylate, isooctyl (meth)acrylate, nonyl (meth)acrylate, decyl (meth)acrylate, isodecyl (meth)acrylate, tridecyl (meth)acrylate, undecyl (meth)acrylate, lauryl (meth)acrylate, stearyl (meth)acrylate, isostearyl (meth)acrylate, tetrahydrofurfuryl (meth)acrylate, butoxyethyl (meth)acrylate, ethoxydiethylene glycol (meth)acrylate, phenoxyethyl (meth)acrylate, polypropylene glycol (meth)acrylate, methoxyethylene (meth)acrylate, ethoxyethyl (meth)acrylate, methoxypolyethylene glycol (meth)acrylate, methoxypolypropylene glycol (meth)acrylate, *beta*-carboxyethyl (meth)acrylate, phthalic acid (meth)acrylate, dimethylaminoethyl (meth)acrylate, diethylaminoethyl (meth)acrylate, butylcarbamylethyl (meth)acrylate, fluorinated (meth)acrylate, and 7-amino-3,7-dimethyloctyl (meth)acrylate.

Preferably, hydrophobic, low viscous and not too brittle acrylates are selected. In particular, 2-ethylhexyl (meth)acrylate, and isobornyl (meth)acrylate are preferred.

Bi- or polyfunctional acrylates may be selected as radiation curable monomers and/or as crosslinking agents. Examples of bi- or polyfunctional acrylates include trimethylolpropane tri(meth)acrylate, pentaerythritol (meth)acrylate, ethylene glycol di(meth)acrylate, bisphenol A diglycidyl ether di(meth)acrylate, bisphenol A di(meth)acrylate, dicyclopentadiene dimethanol di(meth)acrylate, dipentaerythritol monohydroxypenta(meth)acrylate, propoxylated trimethylolpropane tri(meth)acrylate, propoxylated neopentyl glycol di(meth)acrylate, tetraethylene glycol di(meth)acrylate, polyethylene glycol di(meth)acrylate, 1,4-butanediol di(meth)acrylate, 1,6-hexanediol di(meth)acrylate, neopentyl glycol di(meth)acrylate, polybutanediol di(meth)acrylate, tripropyleneglycol di(meth)acrylate, glycerol tri(meth)acrylate, phosphoric acid mono- and di(meth)acrylates, C₇-C₂₀ alkyl di(meth)acrylates, *tris*(2-hydroxyethyl)isocyanurate tri(meth)acrylate, tris(2-hydroxyethyl)isocyanurate di(meth)acrylate, pentaerythritol tri(meth)acrylate, pentaerythritol tetra(meth)acrylate, dipentaerythritol hexa(meth)acrylate, tricyclodecane diyl dimethyl di(meth)acrylate and alkoxylated versions of any of the preceding monomers, and also di(meth)acrylate of a diol which is an ethylene oxide or propylene oxide adduct to bisphenol A, di(meth)acrylate of a diol which is an ethylene oxide or propylene oxide adduct to hydrogenated bisphenol A, epoxy (meth)acrylate which is a (meth)acrylate adduct to bisphenol A of diglycidyl ether, diacrylate of polyoxyalkylated bisphenol A, and triethylene glycol divinyl ether, and adducts of hydroxethyl acrylate.

In particular, trimethylolpropane triacrylate, trimethylolpropane trimethylacrylate, and ethylene glycol di(meth)acrylate are preferred.

The expressions *"cured", "curable",* and *"curing"* are meant to include the susceptibility of the high internal phase emulsion to processes during which a chemical reaction or chemical reactions and/or physical action or physical actions takes place. The result of such processes is the transformation of the high internal phase emulsion into a harder, tougher, more stable linkage and/or solid or gel-like substance. These processes require maintenance of certain parameters, such as temperature, humidity, pressure and/or ultraviolet radiation.

Hydrophilic three-dimensional articles may be formed by the addition of one or more hydrophilic monomers to w/o emulsions before or during the curing process. Preferably, the one or more hydrophilic monomers may be added to an already emulsified system to form a hydrophilic three-dimensional article. The hydrophilic monomers may reside on the interface between the continuous and discontinuous phase. The hydrophilic monomer may be selected from the group consisting of poly(ethylene glycol) acrylates, poly(ethylene glycol) methacrylates and sulphonated (meth)acrylates. In particular, poly(ethylene glycol) (meth)acrylate is preferred. The number average molecular weight (Mₙ) of poly(ethylene glycol) methacrylate may be 100-2000 g/mol. The preferred number average molecular weight (Mₙ) of poly(ethylene glycol) methacrylate is 360 g/mol.

The at least two radiation curable monomers present in the emulsion contribute to the polymerisation and/or curing of the high internal phase emulsion. The monomers may be present in the emulsion in an amount of 30 % or less, by total volume of the emulsion. The preferred amount at which the at least two monomers may be present is 25 % or less by total volume of the emulsion, 20 % or less, 15% or less, or 10 % or less. The amount of monomers can, for instance, be in the range of 5-30 vol.%.

The high internal phase emulsion comprises a photoinitiator. Typically, photoinitiators are divided into those that form radicals by cleavage, known as "Norrish Type I" and those that form radicals by hydrogen abstraction, known as "Norrish Type II". The Norrish Type II photoinitiators require a hydrogen donor, which serves as the free radical source. As the initiation is based on a bimolecular reaction, Norrish Type II photoinitiators are generally slower than Norrish Type I photoinitiators which are based on the unimolecular formation of radicals. On the other hand, Norrish Type II photoinitiators possess better optical absorption properties in the near-ultraviolet spectroscopic region. Photolysis of aromatic ketones, such as benzophenone, thioxanthones, benzyl, and quinones, in the presence of hydrogen donors, such as alcohols, amines, or thiols leads to the formation of a radical produced from the carbonyl compound (ketyl-type radical) and another radical derived from the hydrogen donor. The photopolymerisation of vinyl monomers is usually initiated by the radicals produced from the hydrogen donor. The ketyl radicals are usually not reactive toward vinyl monomers because of the steric hindrance and the delocalisation of an unpaired electron.

It may be necessary to review the wavelength sensitivity of the photoinitiator(s) present in the high internal phase emulsion to determine if they will be activated by the radiation source chosen to provide the curing light. The preferred wavelength range is 300-500 nm. The radiation source may comprise visible light, ultraviolet light, infrared, or electron-beam.

The photoinitiator may comprise one or more selected from the group consisting of benzoyl phosphine oxides, aryl ketones, benzophenones, hydroxylated ketones, 1-hydroxyphenyl ketones, ketals, metallocenes, and any combination thereof.

Suitable examples of photoinitiators include 2,4,6-trimethylbenzoyl diphenylphosphine oxide, 2,4,6-trimethylbenzoyl phenylphosphine oxide, *bis*(2,4,6-trimethylbenzoyl)-phenylphosphine oxide, 2-methyl-1-[4-(methylthio)phenyl]-2-morpholinopropanone, 1,2-benzyl-2-(dimethylamino)-1[4-(4-morpholinyl)phenyl]-1-butanone, 2-dimethylamino-2-(4-methyl-benzyl)-1-(4-morpholin-4-yl-phenyl)-butan-1-one, 4-benzoyl-4'-methyl diphenyl sulphide, 4,4'-*bis*(diethylamino)benzophenone, 4,4'-*bis*(*N,N*'-dimethylamino)benzophenone, benzophenone, 4-methyl benzophenone, 2,4,6-trimethyl benzophenone, dimethoxybenzophenone, 1-hydroxycyclohexyl phenyl ketone, phenyl(1-hydroxyisopropyl)ketone, 2-hydroxy-1-[4-(2-hydroxyethoxy)phenyl]-2-methyl-1-propanone, 4-isopropylphenyl(1-hydroxyisopropyl)ketone, oligo-[2-hydroxy-2-methyl-1-4-(1-methylvinyl)phenyl]propanone], camphorquinone, 4,4'-*bis*(diethylamino)benzophenone, benzyl dimethyl ketal, *bis*(eta(5)-2,4-cyclopentadien-1-yl), and *bis*[2,6-difluoro-3-(1-hydro-pyrrol-1-yl)phenyl]titanocene.

For light source emitting in the 300-475 nm wavelength range, suitable examples of photoinitiators absorbing in this area include benzoylphosphine oxides, such as 2,4,6-trimethylbenzoyl diphenylphosphine oxide, 2,4,6-trimethylbenzoyl phenyl, *bis*(2,4,6-trimethylbenzoyl)-phenylphosphineoxide, 2-methyl-1-[4-(methylthio)phenyl]-2-morpholinopropanone-1, 2-benzyl-2-(dimethylamino)-1-[4-(4-morpholinyl) phenyl]-1-butanone, 2-dimethylamino-2-(4-methyl-benzyl)-1-(4-morpholin-4-yl-phenyl)-butan-1-one, 4-benzoyl-4'-methyl diphenyl sulphide, benzophenone, and 4,4'-*bis*(*N,N'*-dimethylamino)benzophenone.

In addition, it may be useful to add photosensitisers in conjunction with the photoinitiator(s), primarily with Norrish Type II photoinitiators, as it may effect curing with light sources emitting in this wavelength range. Suitable examples of photosensitisers include anthraquinones, such as 2-methylanthraquinone, 2-ethylanthraquinone, 2-*t*-butylanthraquinone, 1-chloroanthraquinone, and 2-amylanthraquinone, thioxanthones and xanthones, such as isopropyl thioxanthone, 2-chlorothioxanthone, 2,4-diethylthioxanthone, and 1-chloro-4-propoxythioxanthone, methyl benzoyl formate, methyl-2-benzoyl benzoate, 4-benzoyl-4'-methyldiphenylsulphide, and 4,4'-*bis*(diethylamino) benzophenone.

When a light source emitting at the ultraviolet spectrum, suitable examples of photoinitiators may include benzophenones, such as benzophenone, 4-methyl benzophenone, 2,4,6-trimethyl benzophenone, dimethoxybenzophenone, and 1-hydroxyphenyl ketones, such as 1-hydroxycyclohexyl phenyl ketone, phenyl (1-hydroxyisopropyl)ketone, 2-hydroxy-1-[4-(2-hydroxyethoxy) phenyl]-2-methyl-1-propanone, and 4-isopropylphenyl (1-hydroxyisopropyl)ketone, benzyl dimethyl ketal, and oligo-[2-hydroxy-2-methyl-1-[4-(1-methylvinyl)phenyl] propanone.

When a radiation source is selected that emits at higher wavelengths (*e.g.* 475-900 nm), suitable examples of photoinitiators may include camphorquinone, 4,4'-*bis*(diethylamino) benzophenone, 4,4'-*bis*(*N,N'*-dimethylamino) benzophenone, *bis*(2,4,6-trimethylbenzoyl-phenylphosphineoxide, and metallocenes, such as *bis*(eta(5)-2,4-cyclopentadien-1-yl), and *bis*[2,6-difluoro-3-(1-hydro-pyrrol-1-yl) phenyl] titanocene.

The photoinitiator present in the high internal phase emulsion may in particular comprise one or more selected from the group consisting of *bis*-acylphosphine oxides, alpha-aminoketones or alpha-hydroxyketones, and derivatives thereof, such as: phenyl *bis*(2,4,6-trimethyl benzoyl) phosphine oxide, diphenyl(2,4,6-trimethylbenzoyl)-phosphine oxide, and 2-hydroxy-2-methyl-1-phenyl-1-propanone. A mixture of one or more phosphine oxides and one or more hydroxyl ketones (*e.g*. Omnirad® 2022) and *bis*-acylphosphine oxides are preferred. Most preferred photoinitiator is Omnirad® 2022.

The photoinitiator may be present in the emulsion in an amount of up to 5 %, based on the total weight of the emulsion. Preferably, the amount of photoinitiator is 1 % or more, and 5 % or less, 4 % or less, 3 % or less, or 2 % or less, based on the total weight of the emulsion. More preferably, the photoinitiator is present in an amount of 2-3 wt.%. When the photoinitiator concentration is less than 1 wt.% the polymerisation rate may be adversely affected. More than 5 wt.%, however, may result in too many polymerisation nuclei, short polymer chain lengths, too high exothermic reaction, and/or incomplete dissolution of the photoinitiator, resulting in light scattering.

At least one surfactant is present in the high internal phase emulsion. The surfactant is added to lower the interfacial tension between emulsion and air, as well as between immiscible liquids, which promotes emulsification and the formation of colloidal dispersions. The surfactant may be selected by its hydrophilic-lipophilic balance value (HLB). When a w/o emulsion is prepared, the surfactant may have an HLB value in the range of 0-10, such as in the range of 2-8. In case of an o/w emulsion, the surfactant may have an HLB value in the range of 10-24, such as in the range of 12-22. In cases where the instable emulsion comprises a hydrophilic-lipophilic balance that requires more than one surfactant, a mixture of surfactants may be used.

The surfactant as used herein may comprise an anionic surfactant, cationic surfactant, zwitterionic surfactant and/or a non-ionic surfactant. Preferably, a non-ionic surfactant is selected as this type of surfactants may relatively be more easy to remove after preparing a three-dimensional article. Furthermore, in particular for high internal phase emulsion, the surfactant preferably does not dissolve in the dispersed phase. A non-ionic surfactant can, for example, be selected from the group consisting of fatty alcohol ethoxylates, sorbitan esters, and block copolymers having an average molecular weight of 1-10 kDa.

The concentration of surfactant in the high internal phase emulsion may be from 0.1 % or more to 2 % or less, based on the total weight of the emulsion. When the surfactant concentration is more than 2 wt.%, the residual surfactant content after forming the poly high internal phase emulsion is relatively high, which may result in increased production costs and risk for medical applications. Preferably, the surfactant content is 0.1 wt.% or more and 0.5 wt.% or less. The surfactant content can, for example, be 0.4 wt.% or less, 0.3 wt.% or less, 0.2 wt.% or less, or 0.1 wt.% or less. A preferred amount of surfactant is 0.3-0.5 wt.%.

The high internal phase emulsion may be characterised in that the dynamic viscosity may be 0.01-100 Pa·s or less, measured at 25 °C. Dynamic viscosity as mentioned herein may be determined on an Anton Paar MCR 301, equipped with a CP50-1 measuring cone and PTD200 temperature control unit. When a low surfactant concentration is selected, the high internal phase emulsion may in part be stabilised by raising the dynamic viscosity. An increase in dynamic viscosity may result in a slowed-down Brownian motion of the emulsion droplets (*i.e*. discontinuous phase). A dynamic viscosity of 100 Pa·s or more may adversely influence the quality of the poly high internal phase emulsion after having subjected the high internal phase emulsion to stereolithography. Printing a poly high internal phase emulsion by means of extrusion techniques may require a dynamic viscosity of 30 Pa·s or more. In case of stereolithography, the dynamic viscosity of the emulsion is preferably 0.01 Pa·s or more, and 90 Pa·s or less, 75 Pa·s or less, 65 Pa·s or less, 50 Pa·s or less, or 25 Pa·s or less. More preferably, the dynamic viscosity is ranging between 0.01-30 Pa·s.

The high internal phase emulsion may further comprise one or more additives. The additive may comprise one or more selected from the group consisting of stabilisers, polymerisation initiator, photosensitisers, dye-sensitisers, antioxidants, drying agents, anticlogging agents, crystallisation aids, dyes, and other pigments. In order to obtain an emulsion suitable for storing a salt may be added to prevent Ostwald ripening. The expression *"stabilisers"* as used in the invention is meant to include salts, as salts may contribute to stabilising emulsions. Such salts may comprise calcium chloride hexahydrate, sodium chloride, and/or magnesium chloride. Shelf-life, or storage time, may be improved with additives that stabilise the emulsion. In addition, physical and/or chemical properties of the material obtained after curing the high internal phase emulsion, may be influenced by adding additives. Suitable examples include antioxidants, dyes, and other pigments.

The above-mentioned one or more additives may be present in the high internal phase emulsion in an amount of up to 20 %, based on the weight of the emulsion. The preferred weight percentage at which the one or more additives may be present in the emulsion is 10 % or less, 9 % or less, 8 % or less, 7 % or less, 6 % or less, 5 % or less, 4 % or less, 3 % or less, 2 % or less, or 1 % or less, based on the total weight of the emulsion. A preferred amount of additives is 3-5 wt.%.

The high internal phase emulsion according to the invention may have a discontinuous phase volume fraction up to 0.99, based on the total volume of the emulsion. The volume fraction of the discontinuous phase in the emulsion is 0.73 or more, preferably 0.75 or more, 0.80 or more, 0.85 or more, 0.90 or more, 0.95 or more, or 0.97 or more. In general, the higher the volume fraction of the discontinuous phase the higher the porosity of the polyHIPE. While a high porosity can be advantageous, the mechanical stability may be simultaneously adversely affected. Furthermore, a high volume fraction could increase the viscosity of the HIPE, wherewith the stability may be adversely affected, and/or impede 3D-printing.

The high internal phase emulsions described herein may be stabilised to such an extent that the longevity of stored samples is ensured before further processing. An alternative method of storing high internal phase emulsions is by adding an adequate amount of polymerisation inhibitor, such as monomethyl ether hydroquinone (MEHQ), hydroquinone (HQ), dibutylhydroxytoluene (BHT), and/or 4-*tert*-butylcatechol (TBC). Another method requires storing at ambient or sub ambient temperature, and/or in the absence of any light source. A preferred method comprises storing the oil phase and water phase separate. By doing so the high internal phase emulsion can be prepared at a later stage by mixing the oil and water phase.

The method provided by the invention is a method of preparing a three-dimensional article from the high internal phase emulsion according to the invention. The expression *"three-dimensional article"* as used herein is meant to include a geometrical material having or appearing to have the dimensions length, breadth (width), and depth.

The expression *"support"* as used is meant to include a structure that may serve to support something. Other suitable qualifications of the support may be framework, frame, skeleton, scaffold, and template. The expression refers to a three-dimensional porous structure suitable to support cells during culturing processes and/or tissue growth.

The high internal phase emulsion is prepared by mixing a solvent, at least two radiation curable monomers of which at least one hydrophilic monomer, a photoinitiator, and a surfactant. Optionally, the high internal phase emulsion may further be prepared by adding one or more additives.

The preparation of the high internal phase emulsion and three-dimensional article may be performed at a temperature in the range of 5-55 °C. Preferably, the high internal phase emulsion is prepared at a temperature of 10 °C or more and 50 °C or less. The temperature can, for instance, be 40 °C or less, 35 °C or less, 30 °C or less, 25 °C or less, 20 °C or less, or 15 °C or less. When a temperature above 55 °C is selected, volatility issues may arise during the preparation of the high internal phase emulsion and/or three-dimensional article, concerning the composition. A temperature below 5 °C may adversely affect the viscosity of certain components of the high internal phase emulsion, by which the preparation may be slowed down. In particular, a preferred temperature at which the high internal phase emulsion is prepared is in the range of 15-30 °C, such as in the range of 20-25 °C.

The solvent may be added at a rate dependent on the size of the high internal phase emulsion sample - approximately 5 % per addition, based on the total weight of emulsion.

The three-dimensional article is prepared by curing at least one layer of high internal phase emulsion by means of initiating polymerisation of the emulsion. Curing is performed by exposing the emulsion to radiation (*i.e*. electromagnetic radiation). The high internal phase emulsion may optionally be cured by heating. In particular, electromagnetic radiation is preferred to curing the high internal phase emulsion.

Exposure of one or more layers of the high internal phase emulsion to radiation may be achieved by an energy source and/or radiation source. The radiation source may be capable of emitting electromagnetic radiation.

The poly high internal phase emulsion may optionally be cleaned using solvent. The solvent may be similar to the above-mentioned solvents. In particular, the solvent may comprise a component that is capable of dissolving impurities and/or uncured material. The three-dimensional article may be cleaned by performing ultrasonic cleaning.

When solvent remains present in and/or on the three-dimensional article, the solvent may optionally be removed by means of drying. Preferably, all of the solvent is removed.

The three-dimensional article may further optionally be exposed to radiation. Herewith, the curing may reach near completion of the present curable material (*i.e*. post-curing). In general, the initial curing does not result in a completely cured three-dimensional article. Therefore, the three-dimensional article may be optionally subjected to post-curing, that is by means of electromagnetic radiation and/or heat.

The kit-of-parts provided by the invention can be used for forming the high internal phase emulsion. The kit-of-parts may be adapted for performing the method provided by the invention. The kit-of-parts comprises a first container, comprising an oil phase, a second container, comprising a water phase, and a third container, comprising an oil phase. By having the oil and water phases separate from each other, the shelf-life may significantly be increased. In addition thereto, the kit-of-parts is considered a modular approach to preparing a high internal phase emulsion to the liking of the operator. The high internal phase emulsion according to the invention can be prepared by mixing the contents of the first, second, and third container with each other. Preferably, the contents of the first and second container are mixed prior to mixing with the contents of the third container.

The first container of the kit comprises one or more of: a solvent, and one or more additives. The solvent may be similar to the solvent of the high internal phase emulsion as described herein. Preferably, the solvent comprises one or more selected from the groups consisting of aqueous, and/or polar organic solvents. In addition, the one or more additives preferably comprise one or more selected from the group consisting of stabilisers, such as salts, antioxidants, drying agents, anticlogging agents, crystallisation aids, dyes and pigments.

The second container of the kit comprises one or more of: at least two radiation curable monomers, a photoinitiator, a surfactant, and one or more additives. In particular, the at least two radiation curable monomers can be the same as the radiation curable monomers as part of the high internal phase emulsion as described herein. Preferably, the at least two radiation curable monomers comprise one or more components selected from the group consisting of (meth)acrylates, such as 2-ethylhexyl acrylate, isobornyl acrylate, 2-ethylhexyl methacrylate, and isobornyl methacrylate. The photoinitiator preferably comprises one or more components selected from the group consisting of *bis*-acrylphosphine oxides, α-aminoketones, and α-hydroxyketones. The surfactant preferably comprises one or more components selected from the group consisting of fatty alcohol ethoxylates, block copolymers, and sorbitan esters. In addition, the one or more additives are preferably selected from the group consisting of stabilisers, such as salts, polymerisation initiators, photosensitisers, antioxidants, drying agents, anticlogging agents, crystallisation aids, dyes and pigments.

The third container of the kit comprises at least one hydrophilic monomer. The at least one hydrophilic monomer can be the same as the hydrophilic monomer(s) described herein. Preferably, the at least one hydrophilic monomer comprises one or more selected from the group consisting of poly(ethylene glycol) methacrylates, poly(ethylene glycol) acrylates and sulphonated (meth)acrylates.

The poly high internal phase emulsion can be formed by performing the curing step with a 3D printer, as part of an Additive Manufacturing processes. When the three-dimensional article is formed by 3D printing, the freedom of design increases, and production costs may reduce. In addition, the combination of the method of preparing according to the invention and the use of 3D printing, result in a highly versatile process of obtaining porous materials. When photopolymerisable monomers are present in the high internal phase emulsion, the digital light projecting (DLP) technique is additionally preferred.

The three-dimensional article obtained by the method provided by the invention may have a fine meshed pore structure. The pores are significantly smaller, when compared to the pore sizes obtained by current technologies. In addition, the surface of the article may be more homogeneous.

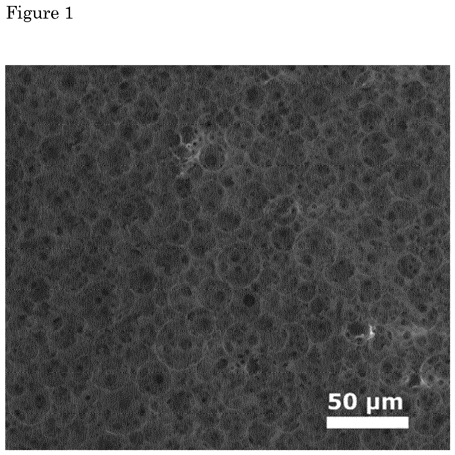

The three-dimensional article according to the invention has an average void diameter of 0.5 µm or more and 100 µm or less. The expression *"void"* as used herein is meant to include the cavities in the three-dimensional article. The preferred average void diameter of the article may be 1 µm or more and 10 µm or less. The average void diameter can, for instance, be 9 µm or less, 8 µm or less, 7 µm or less, 6 µm or less, 5 µm or less, 4 µm or less, 3 µm or less, or 2 µm or less. In particular, the average void diameter may be 1-10 µm. Void diameters above 10 µm may be too large for certain applications, such as cell support, because of cell migration across the article. The average void diameter may be measured by means of microscopy, such as scanning electron microscopy (SEM). The average pore diameter can be calculated from 100 measured pores from a SEM micrograph (figure 1).

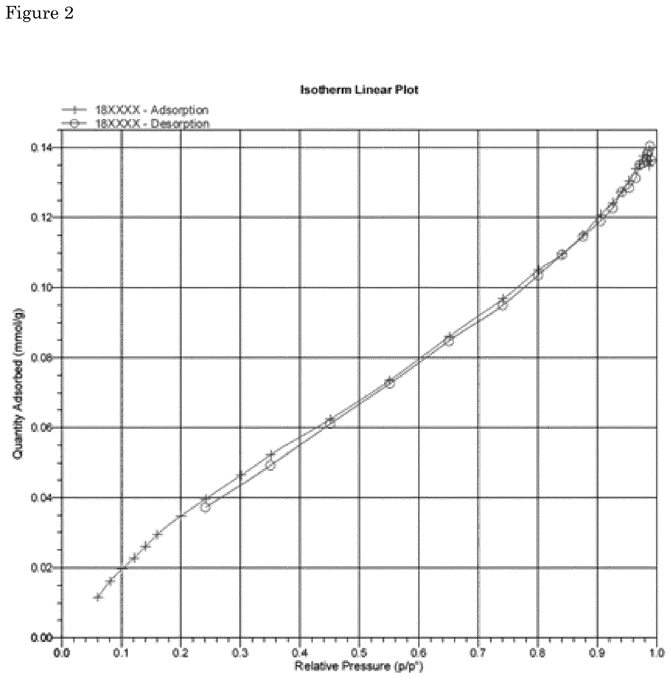

The BET surface area of a typical three-dimensional article is 4.9 m² g⁻¹. The average surface area is measured by means of Brunauer-Emmett-Teller (BET)-analysis using a Micrometrics Gemini V Surface Area and Pore Size Analyzer (figure 2). Before analysis the sample was dried at 60 °C, under vacuum, for 72 hours using a Micromeritics VacPrep 061 Sample Degas system. Preferably, the average surface area of the three-dimensional article is 30 m²g⁻¹ or less, such as 20 m²g⁻¹ or less, or 10 m²g⁻¹ or less. Preferably, the average surface area of the three-dimensional article is 2 m²g⁻¹ or more, such as 3 m²g⁻¹ or more, or 4 m²g⁻¹ or more.

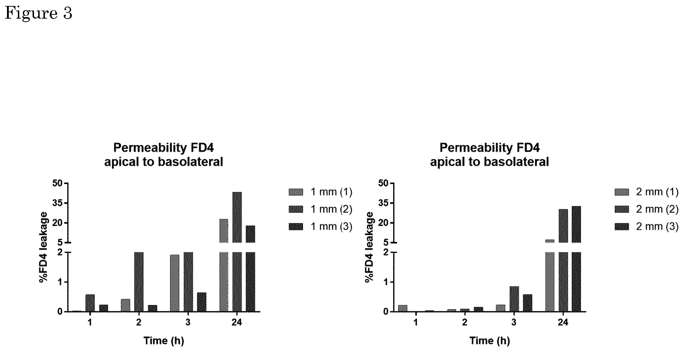

The three-dimensional article according to the invention suitably has good water permeability. Water permeability allows for transport of nutrients (including water) and/or waste products (including water) across the article, which is particular important when the article is used as a support for cell growth, and when used *in vivo.* This can be demonstrated by monitoring the concentration of a water soluble small fluorescent molecule (FD4, fluorescein isothiocyanate-dextran of Merck KGaA), which was introduced on one side of a disk-shaped sample having a thickness of 1 or 2 mm. For both thicknesses transport of FD4 was measured, especially after longer incubation times of 24 hours (figure 3).

The three-dimensional article according to the invention may be used for medical applications. Suitable examples hereof include substrate for culturing cells, implants, encapsulation material for pharmaceutical substances, and membrane on a chip. Preferred articles in accordance with the invention have beneficial properties including, biocompatibility, mechanical performance, a degradation rate which may match the rate of tissue regeneration or targeted drug delivery, and/or highly porous interconnecting structure. During culture the type of cells may require an article that allows media to enter from both the basal and apical surface. This is made possible with the method according to the invention, albeit in combination with 3D printing.

When a three-dimensional article is used as a substrate for culturing cells, the surface of the three-dimensional article may be treated.

Most cells, whether prokaryotic or eukaryotic, may proliferate preferably under hydrophilic conditions. Furthermore, in general, cells experience difficulty attaching to hydrophobic material. When a three-dimensional article is formed of which the surface material is predominantly hydrophobic, application of a coating - preferably a hydrophilic one - may enable its use for culturing cells. The coating may be applied to the three-dimensional article after the forming (and drying) step of the method according to the invention. The expression *"coating"* as used herein is meant to include a layer, a covering, a film, and a deposit. The coating may comprise one or more selected from the group consisting of cell adhesion molecules, such as cadherins, selectins, immunoglobulin superfamily and integrins, such as collagen, fibrinogen, fibronectin, vitronectin and laminin, mucopolysaccharide, such as heparin sulphate, hyaluronidate and chondroitin sulphate or a mixture thereof, and basic synthetic polymers, such as poly(D-lysine) and poly(ethylene glycol) methacrylate.

Another way of raising the surface energy of a three-dimensional article may be by means of treating the article with corona discharge under atmospheric conditions, and/or gas-plasma under vacuum. Herewith, both processes generate highly energetic oxygen ions which oxidise and graft onto the surface.

The invention has been described by reference to various embodiments, and methods. The skilled person understands that features of various embodiments and methods can be combined with each other.

All references cited herein are hereby completely incorporated by reference to the same extent as if each reference were individually and specifically indicated to be incorporated by reference and were set forth in its entirety herein.

The use of the terms "a" and "an" and "the" and similar referents in the context of describing the invention (especially in the context of the claims) are to be construed to cover both the singular and the plural, unless otherwise indicated herein or clearly contradicted by context. The terms "comprising", "having", "including" and "containing" are to be construed as open-ended terms (*i.e*., meaning "including, but not limited to") unless otherwise noted. Recitation of ranges of values herein are merely intended to serve as a shorthand method of referring individually to each separate value falling within the range, unless otherwise indicated herein, and each separate value is incorporated into the specification as if it were individually recited herein. The use of any and all examples, or exemplary language (*e.g.,* "such as") provided herein, is intended merely to better illuminate the invention and does not pose a limitation on the scope of the invention unless otherwise claimed. No language in the specification should be construed as indicating any non-claimed element as essential to the practice of the invention. For the purpose of the description and of the appended claims, except where otherwise indicated, all numbers expressing amounts, quantities, percentages, and so forth, are to be understood as being modified in all instances by the term "about". Also, all ranges include any combination of the maximum and minimum points disclosed and include any intermediate ranges therein, which may or may not be specifically enumerated herein.

Preferred embodiments of this invention are described herein. Variation of those preferred embodiments may become apparent to those of ordinary skill in the art upon reading the foregoing description. The inventors expect skilled artisans to employ such variations as appropriate, and the inventors intend for the invention to be practiced otherwise than as specifically described herein. Accordingly, this invention includes all modifications and equivalents of the subject-matter recited in the claims appended hereto as permitted by applicable law. Moreover, any combination of the above-described elements in all possible variations thereof is encompassed by the invention unless otherwise indicated herein or otherwise clearly contradicted by context. The claims are to be construed to include alternative embodiments to the extent permitted by the prior art.

For the purpose of clarity and a concise description features are described herein as part of the same or separate embodiments, however, it will be appreciated that the scope of the invention may include embodiments having combinations of all or some of the features described.

Hereinafter, the invention will be illustrated in more detail, according to specific examples. However, the invention may be embodied in many different forms and should not be construed as being limited to the embodiments set forth herein. Rather, these example embodiments are provided so that this description will be thorough and complete, and will fully convey the scope of the invention to those skilled in the art.
Figure 1 is a SEM micrograph of a 3D-printed polyHIPE with an average pore diameter of 9.98 µm.
Figure 2 shows a BET analysis of a typical three-dimensional article according to the invention
Figure 3 are two graphs displaying permeability of FD4 on 1 mm thick samples (left) and 2 mm thick samples (right).

### Examples

A mixture of 4.51 g isobornyl methacrylate (Merck KGaA), 21.55 g 2-ethylhexyl acrylate (Merck KGaA), and 7.53 g trimethylolpropane trimethacrylate (Merck KGaA) was mixed at 1200 rpm for 0.5 min using a SpeedMixer™ DAC 800.1. The amount of isobornyl methacrylate included in the resulting high internal phase emulsion was 1.9 wt.%, the amount of 2-ethylhexyl acrylate included in the resulting high internal phase emulsion was 8.9 wt.%, and the amount of trimethylolpropane trimethacrylate included in the resulting high internal phase emulsion was 3.1 wt.%. Once a homogeneous mixture was obtained, 1.25 g Hypermer™ B246 (polymeric surfactant of Croda Lubricants) was added. The resulting mixture was heated to 70 °C until the surfactant was completely dissolved. The amount of Hypermer™ B246 included in the resulting high internal phase emulsion was 0.52 wt.%. 1.03 g Omnirad® 2022 (a mixture of a phosphine oxide and a hydroxy ketone of IGM Resins) and 0.0411 g Quinoline Yellow SS (Sigma Aldrich) were added to the mixture, and stirred by a magnetic stirring rod until complete dissolution. The amount of Omnirad® 2022 included in the resulting high internal phase emulsion was 0.4 wt.%, the amount of Quinoline Yellow SS included in the resulting high internal phase emulsion was 0.017 wt.%. Then, 192 g of water was added in 16 consecutive steps (∼ 5 wt.% per addition), after each step the emulsion was mixed at 1200 rpm for 0.5 min using the speed mixer. 8.04 g of calcium chloride hexahydrate (Merck KGaA) was added to the emulsion. The amount of calcium chloride hexahydrate included in the resulting high internal phase emulsion was 3.3 wt.%. The high internal phase emulsion was obtained by adding 6.03 g poly(ethylene glycol) methacrylate (Mₙ 360 g/mol, Sigma Aldrich) in two addition steps, followed by mixing the resulting emulsion using the speed mixer. The amount of poly(ethylene glycol) methacrylate included in the resulting high internal phase emulsion was 2.5 wt.%.

Several high internal phase emulsions were prepared as described above, with various amounts of Hypermer™ B246 and Quinoline Yellow SS. Viscosity of the emulsions were measured on rheometer MCR 301 (Anton Paar) equipped with a CP50-1 measuring cone and PTD200 temperature control unit. Dynamic viscosities were measured at 25 °C isothermal, with a shear rate profile between 0.01-1000 s⁻¹.

The high internal phase emulsions were subjected to additive manufacturing using a MiiCraft 100X DLP machine with a build area of 102 × 57.5 × 120 mm, and a 350 nm light source having a resolution of 53 µm. Standard build trays and pickers were used. Initial tests were performed to find the appropriate print settings for the desired layer thicknesses, concerning exposure time and reduction of scattering.

The permeability of the poly high internal phase emulsions were measured by measuring the water permeability by monitoring the concentration of a water soluble small fluorescent molecule (FD4, fluorescein isothiocyanate-dextran of Merck KGaA), which was introduced on one side of a disk-shaped sample having a thickness of 1 or 2 mm. The amount of FD4 leakage through the sample can be seen as a measure for the water permeability of the poly high internal phase emulsion.

All the experiments were carried out with notably constant parameters and attributes.

## Claims

1. A high internal phase emulsion comprising:
- a solvent;
- at least two radiation curable monomers of which at least one hydrophilic monomer;
- a photoinitiator, and
- a surfactant,
wherein the high internal phase emulsion has a discontinuous phase volume fraction of 0.73 or more, and wherein the dynamic viscosity of the high internal phase emulsion is 0.01-30 Pa·s and 25 °C.

2. The high internal phase emulsion according to claim 1, wherein the solvent comprises one or more selected from the groups consisting of aqueous, and/or polar organic solvents.

3. The high internal phase emulsion according to claims 1 or 2, wherein the at least two radiation curable monomers comprise one or more components selected from the group consisting of acrylates, such as 2-ethylhexyl (meth)acrylate, isobornyl (meth)acrylate, and poly(ethylene glycol) methacrylate, or bi- or polyfunctional acrylates, such as ethylene glycol di(meth)acrylate, trimethylolpropane triacrylate and trimethylolpropane trimethacrylate.

4. The high internal phase emulsion according to any one of claims 1-3, wherein the at least one hydrophilic monomer comprises one or more selected from the group consisting of poly(ethylene glycol) methacrylate, poly(ethylene glycol) acrylate, and sulfonated (meth)acrylates.

5. The high internal phase emulsion according to any one of claims 1-4, wherein the photoinitiator comprises one or more components selected from the group consisting of *bis*-acylphosphine oxides, alpha-aminoketones or alpha-hydroxyketones, such as phenyl *bis*(2,4,6-trimethyl benzoyl) phosphine oxide, diphenyl(2,4,6-trimethylbenzoyl)-phosphine oxide, and 2-hydroxy-2-methyl-1-phenyl-1-propanone.

6. The high internal phase emulsion according to any one of claims 1-5, wherein the surfactant comprises one or more components selected from the group consisting of fatty alcohol ethoxylates, block copolymers, and sorbitan esters.

7. The high internal phase emulsion according to any one of claims 1-6, further comprising one or more additives selected from the group consisting of stabilisers, such as salts, polymerisation initiators, photosensitisers, antioxidants, drying agents, anticlogging agents, crystallisation aids, dyes, and pigments.

8. A method of preparing a three-dimensional article comprising the following steps:
a) preparing a high internal phase emulsion according to any one of claims 1-7;
b) preparing the three-dimensional article, comprising the steps:
1) applying a layer of the high internal phase emulsion onto a surface;
2) exposing the layer image wise to radiation to form an imaged cross-section;
3) applying a layer of the high internal phase emulsion onto the exposed imaged cross-section;
4) exposing the layer from step 3) to radiation to form an additional imaged cross-section, and
5) repeating steps 3) and 4) to build up the three-dimensional article, and
c) optionally cleaning the three-dimensional article using solvent;
d) optionally removing solvent by drying, and
e) optionally exposing the three-dimensional article to radiation.

9. The method according to claim 8, wherein the at least one hydrophilic monomer is added to the high internal phase emulsion before preparing the three-dimensional article of step b.

10. The method according to claim 8 or 9, wherein the radiation is electromagnetic radiation.

11. A kit-of-parts for forming the high internal phase emulsion according to any one of claims 1-7, the kit comprising,
a first container which comprises one or more of:
- a solvent, and
- one or more additives,
a second container which comprises one or more of:
- at least two radiation curable monomers;
- a photoinitiator;
- a surfactant, and
- one or more additives, and
a third container which comprises:
- at least one hydrophilic monomer.

12. A three-dimensional article obtained by the method according to any one of claims 8-10.

13. The three-dimensional article according to claim 12, having a hydrophilic surface.

14. The three-dimensional article according to claims 12 or 13, having voids with an average void diameter of 0.5-100 µm.

15. A use of the three-dimensional article according to any one of claims 12-14, such as a scaffold for cell growth, medical implants, encapsulation material for pharmaceutical substances, and as a membrane, for example for lab or organ on a chip.
